# EUROPEAN PATENT APPLICATION

(11) **EP 0 774 533 A1**
(43) Date of publication of application: **21.05.1997**
(21) Application number: 96307705.2
(22) Date of filing: 24.10.1996
(51) Int. Cl.: C23C 16/40

(54) **Method for depositing Si-O containing coatings**

(30) Priority: 30.10.1995 US 550261
(71) Applicant: DOW CORNING CORPORATION, Midland Michigan 48686-0994 (US)
(72) Inventor: Loboda, Mark Jon, Midland, Michigan 48640 (US)
(74) Representative: Dowden, Marina

(57) **Abstract**

Coatings containing silicon and oxygen are formed by the chemical vapor deposition of a reactive gas mixture comprising an organosilicon material selected from dimethylsilane and trimethylsilane and an oxygen source. The process comprises introducing the reactive gas mixture into a deposition chamber containing the substrate to be coated and then inducing reaction to form the coating.

## Description

The present invention relates to the vapor deposition of coatings containing silicon and oxygen from an organosilicon material and an oxygen source. The resultant coatings have desirable properties which render them useful in the electronics industry.

Numerous methods for depositing Si-O containing coatings are known in the art and many are currently used in industry. For instance, it is known that silicon oxide coatings can be deposited by the chemical vapor deposition (CVD) of a silane (eg., SiH₄, H₂SiCl₂, etc.) and a source of oxygen (e.g., air, oxygen, ozone, nitrous oxide, etc.). These coatings are valuable as protective or dielectric coatings in the electronics industry. Such methods, however, rely on silanes which are dangerous or difficult to work with.

Similarly, it is known that silicon oxide coatings can be deposited by CVD of tetraethyl orthosilicate (TEOS) and a source of oxygen. These coatings, too, are useful as barriers in the electronics industry. Such methods, however, do not use the organosilicon materials of the present invention.

We have now unexpectedly found that gaseous organosilicon materials can be used in combination with oxygen sources to form superior coatings of silicon and oxygen which are essentially free of carbon.

The present invention relates to a method of depositing a coating containing silicon and oxygen on a substrate. The method comprises introducing a reactive gas mixture comprising an organosilicon material and a source of oxygen into a deposition chamber containing the substrate. The reactive gas mixture is then induced to react to form a coating containing silicon and oxygen.

These coatings have excellent properties which render them valuable as protective and dielectric layers on substrates such as electronic devices. For instance, the coatings have low stress (e.g., less than 100 MPa) and are less likely to damage the coated substrate. Moreover, the process of our invention is advantageous over the prior art in that it eliminates the need for silanes which are a safety hazard (e.g., pyrophoricity).

The organosilicon material of the present invention is any material having Si-C bonds which is in the gaseous state at a temperature less than 500°C. and which will react by the addition of energy to yield silicon for the desired coatings. Examples of specific materials include silanes having organic substituents (e.g., alkylsilanes such as methylsilane, dimethylsilane or trimethylsilane), disilanes having organic substituents (e.g., hexamethyldisilane); trisilanes having organic substituents (e.g., octamethyltrisilane); low molecular weight polysilanes having organic substituents (e.g., dimethylpolysilane), low molecular weight polycarbosilanes and silicon containing cycloalkanes such as the silacyclobutanes or disilacyclobutanes described in US-A 5,011,706. Especially preferred herein is the use of trimethylsilane.

The source of oxygen used in the present invention is any material in the gaseous state at a temperature less than 500°C. which will react by the addition of energy to produce oxygen for the desired coatings. Examples of such materials include air, oxygen, ozone, nitrous oxide, nitric oxide and the like. Especially preferred is the use of oxygen or nitrous oxide.

Naturally, other materials may also be included in the reactive gas mixture. These include, for example, carrier gases such as helium or argon, dopants such as phosphine or borane, halogens such as fluorine or any other material which would impart desirable properties to the coating.

According to the invention, the reactive gas mixture is introduced into a deposition chamber containing the substrate to be coated. If necessary, the organosilicon material and/or the oxygen source may be heated and/or a vacuum created to convert them into the gaseous state for entry into the chamber. If heat is necessary, the materials should generally not be heated above 500°C. to prevent reaction difficulties.

The gases may be introduced into the chamber in any manner desired. For instance, the gases may be mixed prior to entry into the chamber or, alternatively, the materials may be added consecutively or via separate ports. Similarly, the gases may be introduced into the chamber followed by running the reaction (static) or, alternatively, a continuous flow of gaseous material may be introduced and removed from the chamber.

The amount of organosilicon material, oxygen source and any other gaseous components used in the process of this invention is that which is sufficient to deposit the desired coating. This amount can vary over a wide range depending on factors such as the desired coating thickness, the rate of growth, the stoichiometry of the coating and so forth. Generally, the organosilicon material is present in an amount of between 1 and 90 volume percent and the oxygen source is present in an amount of between 1 and 90 volume percent.

Generally, the reactant gases are diluted in a carrier gas to a volume concentration of 75% or less. Typically, the organosilicon material is used in a range of between 1 and 30 vol%; the oxygen source is used in a range of between 1 and 50 vol% and the carrier is used in a range of between 20 and 98 vol%.

The reactive gas mixture is then reacted to deposit the coating on the substrate. Reaction of gaseous species is well known in the art and any conventional CVD technique can be used herein. For example, methods such as simple thermal vapor deposition, photothermal vapor deposition, plasma enhanced chemical vapor deposition (PECVD), electron cyclotron resonance (ECR), jet vapor deposition or any similar technique are adequate. These processes involve the addition of energy (in the form of heat, plasma, etc.) to the vaporized species to cause the desired reaction.

In thermal vapor deposition, the coating is deposited by passing a stream of the reactive gas mixture over a heated substrate. When the reactive gas mixture contacts the hot surface, it reacts and deposits the coating. Substrate temperatures in the range of 100-1000°C. are sufficient to form these coatings in several minutes to several hours, depending on the thickness desired.

In PECVD, the reactive gas mixture is reacted by passing it through a plasma field. The reactive species thereby formed are then focused at the substrate and readily adhere. Generally, the advantage of this process over thermal CVD is that lower substrate temperatures can be used. For instance, substrate temperatures of 20 to 600°C. are functional.

The plasmas used in such processes comprise energy derived from a variety of sources such as electric discharges, electromagnetic fields in the radio-frequency or microwave range, lasers or particle beams. Generally preferred in most plasma deposition processes is the use of radio frequency (10 kHz -10² MHz) or microwave (0.1-10 GHz) energy at moderate power densities (0.1-5 watts/cm²). The specific frequency, power and pressure, however, are generally tailored to the equipment.

Although the mechanism for this deposition is not clearly understood, it is postulated that the addition of energy to the reactive gas mixture causes dissociation and rearrangement of the molecules so that silicon-oxygen bonds are formed on the substrate. The stoichiometry of this coating is generally SiOₓ, wherein x is between 1 and 2, inclusive.

The process of this invention deposits desirable coatings in a wide variety of thicknesses. For instance, coatings in the range of a monolayer to greater than 2-3 micrometers are possible. The coatings are mechanically hard, have a high modulus and are excellent mechanical barriers. As such, they are useful on a wide variety of electronic devices or electronic circuits such as silicon based devices, gallium arsenide based devices, focal plane arrays, opto-electronic devices, photovoltaic cells and optical devices as well as non-electronic substrates such as cutting tools, glass, ceramics, metal and plastics.

These coatings may also be covered by other coatings such as further SiO₂ coatings, SiO₂/modifying ceramic oxide layers, silicon containing coatings, silicon carbon containing coatings, silicon nitrogen containing coatings, silicon nitrogen carbon containing coatings, silicon oxygen nitrogen containing coatings and/or diamond like carbon coatings. Such coatings and their mechanisms of deposition are known in the art. Many are taught in US Patent 4,973,526.

### Examples 1-20

The silane (comparative) or trimethylsilane (present invention), nitrous oxide and helium were introduced into a capacitively coupled parallel plate PECVD system using silicon wafers as the substrates. Coatings were deposited using the array of parameters set forth in Table 1 (all depositions were at 1.0 Pa [1000 mTorr]). The results for the various runs are presented in Table 1.

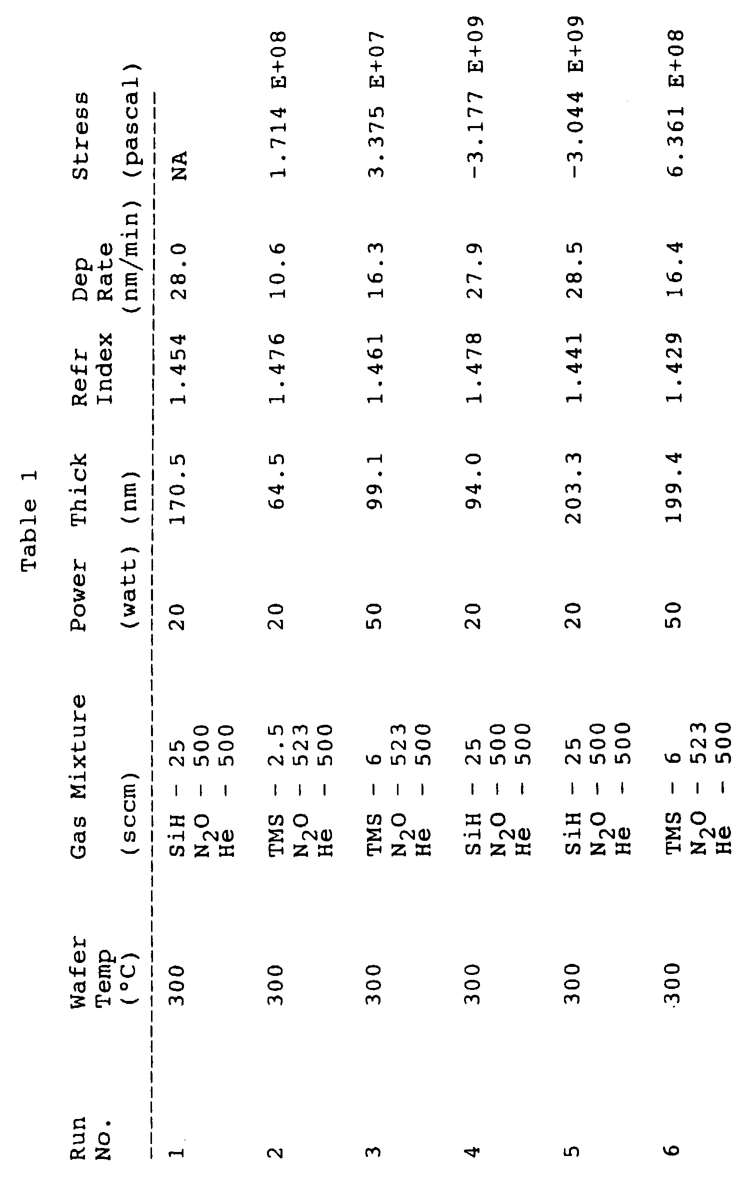

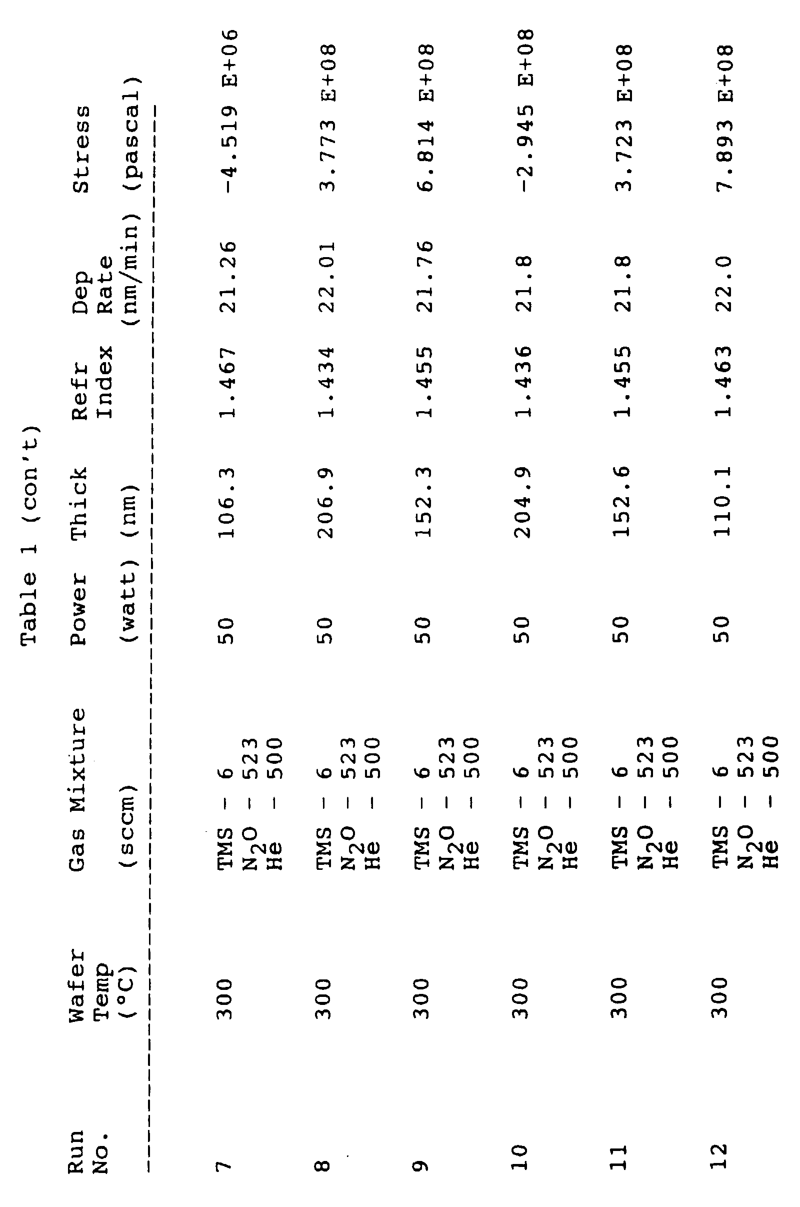

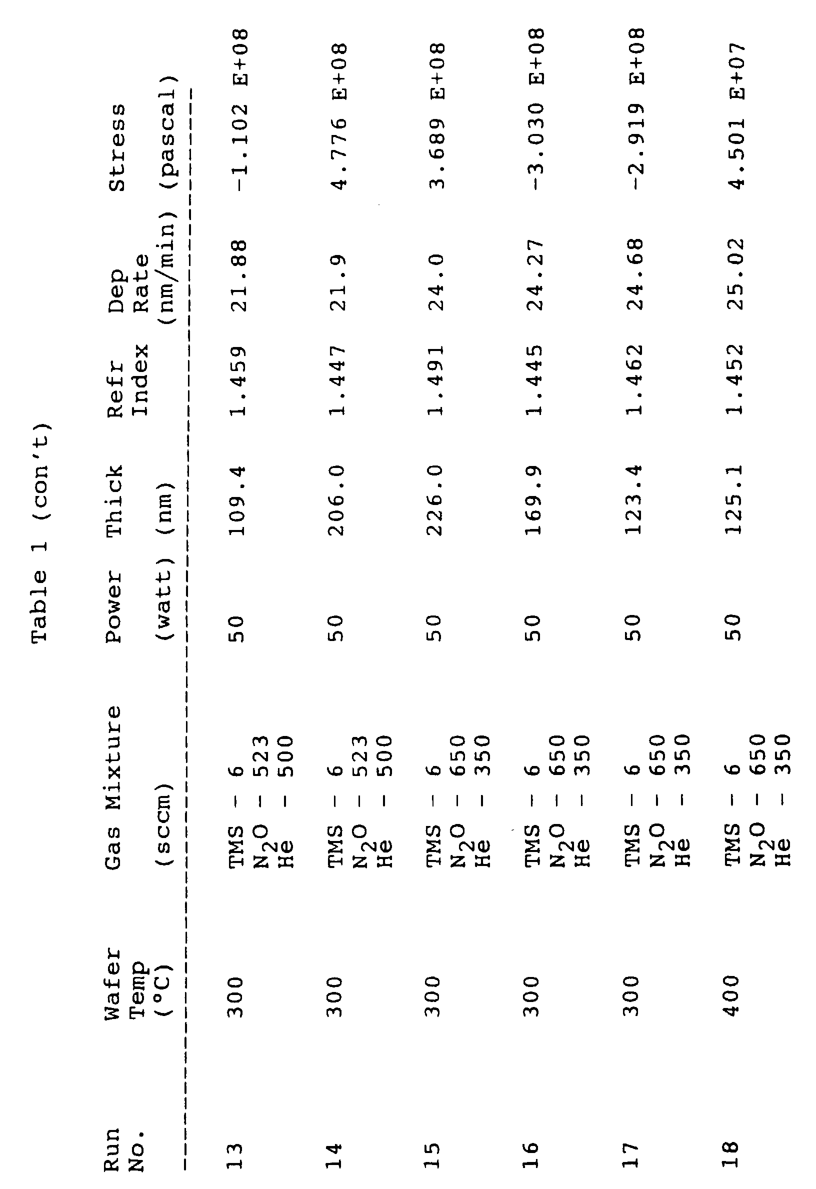

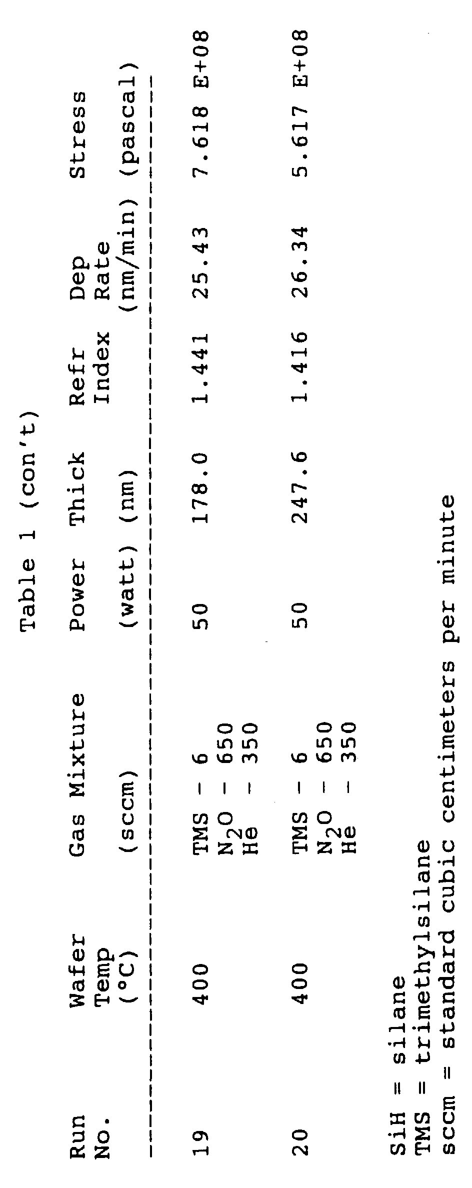

The Table indicates that, under constant RF power to the plasma, the films deposited from silane grew at a higher rate due to its easier dissociation. Such films, however, also have higher stress. As is evident, the growth rate for the trimethylsilane based process (present invention) can be increased to match the silane based process (prior art) by increasing the power.

The films from the trimethylsilane based process show stresses in the range of 30 MPa compressive to 600 MPa tensile. This can be compared to the 300 MPa compressive obtained herein and to the industry average in the region of 100 to 300 MPa compressive, using silane based processes.

FTIR data on the resultant films show essentially no difference between the silane based process and our trimethylsilane based process. FTIR also shows no evidence of C-H bonds in our trimethylsilane process which would result from the incomplete decomposition of the precursor (organosilicon material).

## Claims

1. A method of depositing a coating containing silicon and oxygen on a substrate comprising:
introducing a reactive gas mixture comprising an organosilicon material selected from dimethylsilane or trimethylsilane and a source of oxygen into a deposition chamber containing the substrate; and
inducing reaction of the reactive gas mixture to form the coating containing silicon and oxygen.

2. The method of claim 1 wherein the oxygen source is selected from the group consisting of air, oxygen, ozone and nitrous oxide.

3. The method of claim 1 or claim 2 wherein the reactive gas mixture also comprises a carrier gas selected from helium or argon.

4. The method of any of claims 1 to 3 wherein the reactive gas mixture is induced to react by exposure to an elevated temperature in the range of 100-1000°C.

5. The method of any of claims 1 to 3 wherein the reactive gas mixture is induced to react by exposure to a plasma from radio frequency energy or microwave energy.

6. The method of any of claims 1 to 5 in which the substrate comprises an electronic device.

7. The method of any of claims 1 to 6 in which the reactive gas mixture is a gaseous composition comprising between 1 and 90 volume percent of the organosilicon material and between 1 and 90 volume percent of the source of oxygen.

8. The method of any of claims 1 to 6 in which the reactive gas mixture is a gaseous composition wherein the organosilicon material is present in a range of 1 and 30 vol%, the oxygen source is present in a range of between 1 and 50 vol% and a carrier gas is present in a range of between 20 and 98 vol%.
